# EUROPÄISCHE PATENTSCHRIFT

(11) **EP 3 323 154 B1**
(45) Veröffentlichungstag und Bekanntmachung des Hinweises auf die Patenterteilung: **15.05.2019**
(21) Anmeldenummer: 16736854.7
(22) Anmeldetag: 07.07.2016
(51) Int. Cl.: H01L 35/08, H01L 35/32, H01L 35/30, H01L 35/34

(54) **PELTIER-ELEMENT**
PELTIER ELEMENT
ÉLÉMENT PELTIER

(30) Priorität: 15.07.2015 DE 102015213294; 27.04.2016 DE 102016207190
(43) Veröffentlichungstag der Anmeldung: 23.05.2018
(73) Patentinhaber: MAHLE International GmbH, 70376 Stuttgart (DE)
(72) Erfinder: GRÜNWALD, Jürgen, 71638 Ludwigsburg (DE); HENEKA, Christian, 76227 Karlsruhe (DE); NEUMEISTER, Dirk, 70374 Stuttgart (DE)
(74) Vertreter: BRP Renaud & Partner mbB Rechtsanwälte Patentanwälte Steuerberater
(86) Internationale Anmeldenummer: PCT/EP2016/066137
(87) Internationale Veröffentlichungsnummer: WO 2017/009172

(56) Entgegenhaltungen:
- EP-A1- 2 698 833
- WO-A1-2014/135600
- WO-A2-2012/095344
- DE-A1-102012 105 743
- JP-A- 2001 274 467

## Beschreibung

Die vorliegende Erfindung betrifft ein Peltier-Element mit abwechselnd angeordneten, in Reihe geschalteten N-Halbleitern und P-Halbleitern. Die Erfindung betrifft desweiteren ein Verfahren zum Herstellen eines solchen Peltier-Elements sowie einen thermoelektrischen Wärmeübertrager mit einem solchen Peltier-Element.

Thermoelektrische Wärmeübertrager kommen in zahlreichen Anwendungen zum Einsatz und erlauben das Pumpen von Wärme von einer ersten auf eine zweite Seite. Dieses Pumpen der Wärme kann insbesondere dazu eingesetzt werden, um einen Wärmeaustausch zwischen den Seiten zu verstärken oder Wärme von der kälteren Seite auf die wärmere Seite zu übertragen. Solche thermoelektrische Wärmeübertrager können zum Realisieren des Wärmepumpens ein Peltier-Element aufweisen. Übliche Peltier-Elemente weisen eine Vielzahl von p-dotierten P-Halbleitern und eine Vielzahl von n-dotierten N-Halbleitern auf, die abwechselnd angeordnet und in Reihe geschaltet sind. Zum elektrischen Kontaktieren von benachbarten Halbleitern kommen gewöhnlich Metallplatten zum Einsatz, die auch als Brücken bezeichnet werden. Diese Metallplatten sind entlang des Peltier-Elements abwechselnd auf einer ersten und auf einer zweiten Seite angeordnet und bilden somit eine erste bzw. eine zweite Seite des Peltier-Elements.

Zur elektrischen Isolierung wird die jeweilige Seite gewöhnlich mit einer dielektrischen Schicht versehen. Zum Wärmeaustausch werden die Seiten üblicherweise zudem mit einer thermischen Schnittstelle versehen. Dabei kommen in der Regel Keramikplatten zum Einsatz, die als solche thermische Schnittstellen dienen und elektrisch isolierend sind. Um insbesondere einen Wärmeaustausch mit größeren Gegenständen zu erlauben, sind zugehörige Wärmeübertrager gewöhnlich ferner mit einer Platte versehen, die gewöhnlich eine Metallplatte sind und einen gleichmäßigeren Wärmeaustausch zwischen dem Peltier-Element und einem mit dem Peltier-Element in wärmeaustauschenden Kontakt stehenden Körper erlauben. Derartige Platten bzw. Metallplatten werden gewöhnlich als "Heat Spreader" bezeichnet.

Hierdurch ergeben sich für übliche Peltier-Elemente sowie zugehörige thermoelektrische Wärmeübertrager, die mit einem solchen Peltier-Element ausgestattet sind, ein starrer Aufbau. Im Betrieb des Peltier-Elements bzw. des zugehörigen Wärmeübertragers kommt es dabei zu thermisch bedingten Spannungen innerhalb des Peltier-Elements, die aufgrund der starren Ausgestaltung nicht oder nicht ausreichend ausgeglichen werden können. Zudem weisen solchen Peltier-Elemente zwischen den eigentlich zu temperierenden Temperierpartner einen erhöhten thermischen Widerstand auf, die insbesondere durch die zwischen diesen Partnern vorhandenen Bestandteile wie bspw. der Metallbrücken, der dielektrischen Schicht bzw. der Metallplatte bedingt sind und zu einer geringen Effizienz führen. Derartige Metallplatten dienen dabei insbesondere dem Zweck, lokale Temperaturdifferenzen, sogenannte Hot Spots, auszugleichen. Sind hierbei größere, insbesondere größerflächigere Peltier-Elemente, notwendig, so kann sich die Ausbildung solcher Hot Spots vermehren bzw. verstärken. Dem wird üblicherweise mit dickeren Metallplatten bzw. Heat Spreader entgegengewirkt, die jedoch wiederum zu einer Erhöhung des thermischen Widerstandes und einer Reduzierung der Effizienz führt. Der Aufbau des Peltier-Elements führt zudem zu einer gewissen Mindestdicke des Peltier-Elements, welche den Einsatz des Peltier-Elements in engen zur Verfügung stehenden Bauräumen erschwert oder nicht erlaubt.

Die WO 2012/095344 A2 zeigt einen thermoelektrischen Wärmeübertrager mit einem Peltierelement, welches Halbleiter aufweist, die mittels einer Blechstruktur elektrisch kontaktiert und miteinander verbunden sind. Aus der WO 2014/135600 A1 ist ein Peltierelement mit einer Blechstruktur und Halbleitern bekannt, welche mittels der Blechstruktur miteinander kontaktiert sind.

Die vorliegende Erfindung beschäftigt sich daher mit der Aufgabe, für ein Peltier-Element, für ein Verfahren zum Herstellen eines solchen Peltier-Elements sowie für einen thermoelektrischen Wärmeübertrager mit einem solchen Peltier-Element verbesserte Ausführungsformen anzugeben, die sich insbesondere durch eine erhöhte Effizienz und/oder einen vereinfachten Einsatz auszeichnen.

Diese Aufgabe wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, Halbleiter eines Peltier-Elements mit einer Blechstruktur elektrisch miteinander zu verbinden und somit zu kontaktieren und die Blechstruktur zugleich zur Wärmeübertragung einzusetzen. Der Einsatz der Blechstruktur führt zu einer Flexibilität des Peltier-Elements, welche den Abbau von im Betrieb entstehenden thermischen Spannungen erleichtert und/oder einen flexibleren Einsatz des Peltier-Elements und somit den Einsatz des Peltier-Elements bzw. eines zugehörigen Wärmeübertragers in unterschiedlichen räumlichen Gegebenheiten und/oder in unterschiedlichen Geometrien erlaubt.

Dem Erfindungsgedanken entsprechend weist das Peltier-Element n-dotierte N-Halbleiter, p-dotierte P-Halbleiter sowie die Blechstruktur auf. Die Blechstruktur weist erste Blechabschnitte sowie zweite Blechabschnitte auf, die entlang der Erstreckung des Peltier-Elements abwechselnd angeordnet sind, wobei die ersten Blechabschnitte eine erste Seite des Peltier-Elements und die zweiten Blechabschnitte eine von der ersten Seite beabstandete zweite Seite des Peltier-Elements bilden. Die Blechstruktur weist zudem mehrere Schenkel auf, wobei die Schenkel entlang des Peltier-Elements benachbarte Blechabschnitte miteinander verbinden und geneigt, das heißt mit einem Winkel, insbesondere auch quer, zu den zugehörigen Blechabschnitten verlaufen. Das heißt, dass jeweils ein solcher Schenkel die entlang des Peltier-Elements benachbarten Blechabschnitte miteinander verbindet, derart, dass jeweils ein solcher Schenkel einen solchen ersten Blechabschnitt mit einem solchen zweiten Blechabschnitt verbindet und geneigt zu diesen Blechabschnitten verläuft. Dabei sind die Halbleiter des Peltier-Elements beabstandet zueinander in den Schenkeln der Blechstruktur integriert. Das heißt, dass entlang der Blechstruktur abwechselnd ein solcher N-Halbleiter und ein solcher P-Halbleiter in den Schenkeln integriert sind. Die Integration des jeweiligen Halbleiters in die zugehörigen Schenkel erfolgt dabei derart, dass N-Halbleiter und P-Halbleiter entlang der Blechstruktur abwechselnd angeordnet und mittels der Blechstruktur in Reihe geschaltet sind. Insbesondere sind die Blechabschnitte frei von Halbleitern.

Durch eine derartige Anordnung der Blechabschnitte und der Schenkel weist die Blechstruktur und somit das Peltier-Element also insbesondere eine innere gewellte Form auf, welche insbesondere die Flexibilität des Peltier-Elements verbessert.

Im Betrieb des Peltier-Elements wird eine Spannung an die Blechstruktur angelegt und das Peltier-Element somit bestromt. In der Folge kommt es zum eingangs erwähnten Pumpen von Wärme. Die Richtung des Wärmeflusses kann hierbei durch eine Umkehrung der Bestromung des Peltier-Elements umgekehrt werden. Durch die direkte Integration der Halbleiter in die Blechstruktur, die sowohl zur elektrischen Kontaktierung der Halbleiter als auch zur Wärmeübertragung eingesetzt wird, werden die Halbleiter also in die wärmeübertragende Struktur direkt integriert. Dies führt dazu, dass zusätzliche, wärmeübertragende Strukturen entfallen können oder dass die Anzahl der wärmeübertragenden Strukturen zumindest reduziert werden kann. Hierdurch wird die Ausbildung des Peltier-Elements weniger starr und/oder der thermische Widerstand innerhalb des Peltier-Elements oder der zugehörigen Anwendung, insbesondere in einem zugehörigen thermoelektrischen Wärmeübertrager, reduziert.

Die Integration der Halbleiter in die Blechstruktur erfolgt zweckmäßig derart, dass kein elektrische Kurzschluss bzw. den jeweiligen Halbleiter übergehende Überbrückung entsteht. Dies erfolgt bevorzugt dadurch, dass der Schenkel zur Integration des Halbleiters elektrisch unterbrochen ist, wobei innerhalb dieser elektrischen Unterbrechung die Integration des Halbleiters erfolgt, derart, dass ein elektrischer Strom durch die Unterbrechung ausschließlich über den Halbleiter möglich ist. Hierzu kann der Schenkel zur besagten Unterbrechung zwei voneinander beabstandete Schenkelabschnitte aufweisen, die insbesondere abgebogen sind, wobei der Halbleiter zwischen diesen Schenkelabschnitten angeordnet ist und diese elektrisch kontaktiert.

Die erste Seite und die zweite Seite des Peltier-Elements können prinzipiell beliebig verlaufen, sofern sie voneinander beabstandet sind. Vorstellbar ist es insbesondere, dass die jeweilige Seite zumindest abschnittsweise einen gekrümmten Verlauf aufweist. Dabei sind Ausgestaltungen vorstellbar, bei denen die erste Seite und die zweite Seite zumindest abschnittsweise nicht parallel verlaufen.

Zu denken ist auch an Ausführungsformen, bei denen die erste Seite und die zweite Seite einander gegenüberliegend angeordnet sind. Vorstellbar ist es hierbei insbesondere, dass die erste Seite und die zweite Seite entlang des Peltier-Elements im Wesentlichen äquidistant sind.

Vorstellbar sind auch Ausführungsformen, bei denen die ersten Blechabschnitte in einer ersten Ebene liegen, während die zweiten Blechabschnitte in einer von der ersten Ebene beabstandeten zweiten Ebene angeordnet sind, wobei die Ebenen insbesondere parallel verlaufen. Die jeweilige Ebene kann hierbei zumindest abschnittsweise gekrümmt verlaufen.

Bei bevorzugten Ausführungsformen sind die ersten Blechabschnitte und die zweiten Blechabschnitte, insbesondere durch die parallele Anordnung der ersten Seite zur zweiten Seite, parallel zueinander angeordnet. Dies führt insbesondere zu einem besseren Abbau von thermischen Spannungen im Peltier-Element. Bevorzugt ist es ferner, wenn die Schenkel, zumindest jeder zweite Schenkel entlang des Peltier-Elements, ebenfalls parallel verlaufen. Auch dies führt zu einer Verbesserung des Abbaus thermischer Spannungen. Insbesondere ist es hierdurch auch möglich, die Flexibilität des Peltier-Elements in mehreren Richtungen und somit einen entsprechenden Abbau von thermischen Spannungen in mehrere Richtungen und/oder eine elastische Verformung des Peltier-Elements in mehrere Richtungen zu erlauben und/oder zu verbessern.

Das Anlegen einer elektrischen Spannung zum Betreiben des Peltier-Elements erfolgt, wie vorstehend erwähnt, über die Blechstruktur. Dabei weist die Blechstruktur vorteilhaft an gegenüberliegenden Enden entsprechende elektrische Anschlüsse auf, die eine Bestromung des Peltier-Elements erlauben. Somit können weitere Bestandteile und elektrische Anschlüsse des Peltier-Elements zur Bestromung entfallen und der Aufbau des Peltier-Elements bzw. des zugehörigen Wärmeübertragers somit einfacher und kostengünstiger ausgestaltet werden.

Das Peltier-Elements weist vorteilhaft eine thermische Isolierung zwischen der ersten Seite und der zweiten Seite auf, die einen thermischen Kurschluss und somit einen unbeabsichtigten Wärmefluss zwischen der ersten Seite und der zweiten Seite verhindert oder zumindest reduziert. Thermisch isolierend heißt den Wärmeaustausch zumindest reduzierend. Vorstellbar ist es auch, die erste Seite und die zweite Seite fluidisch voneinander zu trennen bzw. zu isolieren.

Kommt eine der Seiten des Peltier-Elements bei der Anwendung des Peltier-Elements mit einem elektrisch leitenden Gegenstand bzw. Körper in Kontakt, so ist bevorzugt, wenn die zugehörigen Blechabschnitte auf der entsprechenden Seite elektrisch isoliert sind, um einen elektrischen Kurzschluss im Peltier-Element zu vermeiden. Eine solche elektrische Isolierung kann insbesondere durch Lack bzw. durch Lackieren, durch Eloxieren und dergleichen erfolgen.

Der jeweilige Halbleiter kann ein einziges Halbleiterelement aufweisen. Vorstellbar ist es auch, dass zumindest einer der Halbleiter mehrere Halbleiterelemente mit gleichartiger Dotierung aufweist.

Prinzipiell ist es vorstellbar, im jeweiligen Schenkel des Peltier-Elements eine beliebige Anzahl von Halbleitern zu integrieren, sofern diese abwechselnd angeordnet sind.

Vorstellbar ist es insbesondere, dass im jeweiligen Schenkel ein einziger solcher Halbleiter integriert ist. In diesem Fall erfolgt im Betrieb des Peltier-Elements das Pumpen von Wärme von einer Seite des Peltier-Elements auf die andere Seite des Peltier-Elements. Durch eine Umkehrung der Bestromung des Peltier-Elements kann eine Umkehrung des Wärmeflusses erreicht werden, so dass Wärme von der zweiten Seite auf die erste gepumpt wird.

Zu denken ist auch an Varianten, bei denen das Peltier-Element im jeweiligen Schenkel zwei solche Halbleiter, nämlich einen solchen N-Halbleiter und einen solchen P-Halbleiter aufweist. Hierdurch wird Wärme, je nach Bestromung des Peltier-Elements, von den besagten Abschnitten der Schenkel auf beiden Seiten des Peltier-Elements gepumpt oder, bei Umkehrung der Bestromung, umgekehrt.

Bevorzugt ist es hierbei, wenn besagte Abschnitte der Schenkel in einem Strömungsraum des Peltier-Elements angeordnet sind, der von einem zu temperierenden Fluid durchströmbar ist. Somit kann das Fluid mittels der besagten, zwischen den Halbleitern des jeweiligen Schenkels liegenden Abschnitte erwärmt werden und somit als Wärmesenke dienen, während die erste Seite und die zweite Seite des Peltier-Elements gekühlt werden. Durch eine Umkehrung der Bestromung des Peltier-Elements kann das Fluid gekühlt werden und somit als Wärmequelle dienen, während beide Seiten des Peltier-Elements erwärmt werden. Dies erlaubt eine besonders effiziente Temperierung des Fluids.

Eine solche Ausgestaltung des Peltier-Elements kann derart ausgestaltet sein, dass der Strömungsraum zwischen den ersten Blechabschnitten und den zweiten Blechabschnitten angeordnet ist, wobei einer der Halbleiter des jeweiligen Schenkels auf der ersten Seite außerhalb des Strömungsraums und der andere Halbleiter auf der zweiten Seite außerhalb des Strömungsraums angeordnet ist. Das heißt, dass die Halbleiter jeweils außerhalb des Strömungsraums angeordnet sind.

Besonders bevorzugt ist es hierbei, wenn die auf der ersten Seite angeordneten Halbleiter und die ersten Blechabschnitte und/oder die auf der zweiten Seite angeordneten Halbleiter und die zweiten Blechabschnitte gegenüber dem Strömungsraum thermisch isoliert ist/sind und somit zu einer effizienteren Temperierung des Fluids führen. Die thermische Isolierung kann hierbei insbesondere durch eine Integration, insbesondere Einbettung, der auf der ersten Seite angeordneten Halbleiter und der ersten Blechabschnitte in einen thermisch isolierenden Block erfolgen, wobei der Block den Strömungsraum begrenzen kann. Entsprechendes gilt für die auf der zweiten Seite angeordneten Halbleiter und die zweiten Blechabschnitte.

Das erfindungsgemäße Peltier-Element kann prinzipiell auf eine beliebige Art hergestellt werden.

Das Herstellen des Peltier-Elements erfolgt bevorzugt durch das Bereitstellen eines Blechs, das mit Aussparungen versehen wird, die entlang des Blechs beabstandet sind. Die jeweilige Aussparung kann hierbei als eine Nut bzw. eine Unterbrechung des Blechs ausgebildet sein. Anschließend erfolgt ein Integrieren von N-Halbleitern und P-Halbleitern in die Aussparungen, wobei die N-Halbleiter und die P-Halbleiter entlang des Blechs abwechselnd angeordnet sind. Das mit den Halbleitern versehene Blech wird dann derart umgeformt, dass die Blechstruktur mit den Halbleitern und somit das Peltier-Element entsteht.

Zur Stabilisierung des Blechs bzw. der Blechstruktur kann das Blech mit einer Trägerplatte versehen werden. Die Trägerplatte ist vorzugsweise einseitig des Blechs der Blechstruktur angeordnet. Hierbei kann das Blech vor dem Umformen und/oder vor dem Integrieren der Halbleiter in die Aussparungen mit der Trägerplatte versehen werden.

Die Trägerplatte kann im Peltier-Element insbesondere zur elektrischen Isolierung der Blechstruktur und somit des Peltier-Elements eingesetzt werden und dementsprechend elektrisch isolierend ausgestaltet sein.

Vorstellbar ist es auch, die Trägerplatte lediglich zur Stabilisierung während der Herstellung des Peltier-Elements einzusetzen und nach dem Umformen des Blechs wieder zu entfernen.

Alternativ kann das Integrieren der Halbleiter in das Blech auch nach dem Umformen des Blechs erfolgen. Das heißt, dass das Blech auch in einem ersten Schritt umgeformt werden und anschließend die Halbleiter in die umgeformte Blechstruktur integriert werden.

Das Peltier-Element kann prinzipiell in einer beliebigen Anwendung zum Einsatz kommen, um das Pumpen von Wärme zu erzielen.

Das Peltier-Element ist bevorzugt in einem thermoelektrischen Wärmeübertrager vorgesehen, der außer dem Peltier-Element einen mit der ersten Seite des Peltier-Elements Wärme austauschenden ersten Körper und einen mit der zweiten Seite des Peltier-Elements wämeaustauschenden zweiten Körper aufweist. Somit kann der jeweilige Körper im Betrieb gekühlt bzw. geheizt werden und folglich als Wärmequelle bzw. Wärmesenke dienen.

Bevorzugt ist es hierbei, wenn alle ersten Blechabschnitte mit dem ersten Körper wärmeübertragend verbunden sind und/oder wenn alle zweiten Blechabschnitte mit dem zweiten Körper wärmeübertragend verbunden sind. Vorstellbar ist es auch, lediglich einen Anteil der ersten Blechabschnitte mit dem ersten Körper wärmeübertragend zu verbinden und/oder lediglich einen Anteil der zweiten Blechabschnitte wärmeübertragend mit dem zweiten Körper zu verbinden.

Der Wärmeübertrager kann dabei insbesondere zur Temperierung eines Fluids und/oder eines Temperiermittels eingesetzt werden. Vorstellbar ist es auch, den Wärmeübertrager zum Temperieren eines Akkumulators oder einer Akkumulatorzelle einzusetzen. Auch ist es vorstellbar, den Wärmeübertrager zum Klimatisieren eines Innenraums, insbesondere als Bestandteil einer Klimaanlage, einzusetzen.

Der jeweilige Körper kann im Betrieb des Wärmeübertragers auch dazu eingesetzt werden, einen weiteren Gegenstand und/oder ein weiteres Fluid bzw. Mittel zu temperieren.

Einer der Körper kann beispielsweise ein flächig ausgebildeter Körper zum Wärmeaustausch mit einem zu kühlenden Gegenstand, bspw. einem Akkumulator, sein. Der Körper ist also insbesondere als ein so genannter Heat Spreader ausgestaltet.

Zumindest einer der Körper kann ferner ein von einem Temperiermittel durchströmbarer Körper, insbesondere Rohrkörper sein, wobei das Temperiermittel im Betreib des Peltier-Elements bzw. des zugehörigen Wärmeübertragers temperiert wird.

Es sind also insbesondere Ausführungsformen vorstellbar, bei denen einer der Körper mit einem Gegenstand, insbesondere einen solchen Akkumulator, Wärme austauscht, während der andere Körper mit einem solchen Temperiermittel Wärme austauscht, so dass es im Betrieb des Wärmeübertragers zum Austausch von Wärme zwischen dem Temperiermittel und dem Gegenstand, insbesondere dem Akkumulator, kommt. Ist der Wärmeübertrager dazu einzusetzen, einen der Körper zu kühlen und den anderen Körper zu erwärmen, so kommt bevorzugt ein solches Peltier-Element zum Einsatz, das im jeweiligen Schenkel lediglich einen solchen Halbleiter aufweist.

Sollen beide Körper als Wärmequelle oder als Wärmesenke eingesetzt werden, kommt bevorzugt ein solches Peltier-Element zum Einsatz, das im jeweiligen Schenkel zwei solche Halbleiter aufweist.

Zu denken ist insbesondere an Ausführungsformen, bei denen ein solches Peltier-Element mit einem solchen Strömungsraum eingesetzt wird, der einen Strömungsraum des Wärmeübertragers bildet, der vom Fluid durchströmbar ist. Im jeweiligen Schenkel sind zudem zwei solche Halbleiter angeordnet. Bevorzugt sind beide Körper von einem Temperiermittel, insbesondere vom gleichen Temperiermittel, durchströmbare Rohrkörper. Auf diese Weise kann das durch den Strömungsraum strömende Fluid über die Rohrkörper mit dem Temperiermittel Wärme austauschen. Das Peltier-Element kann also insbesondere eine zwischen den Rohrkörpern angeordnete Rippenstruktur ersetzen, um den Wärmeaustausch zwischen dem Fluid und dem Temperiermittel zu verstärken und/oder um Wärme vom kälteren Fluid zum wärmeren Temperiermittel zu pumpen bzw. umgekehrt.

Vorstellbar ist es insbesondere auch, dass zumindest einer der Körper ein Textil ist. Hierdurch kann mittels des Peltier-Elements eine entsprechende Kühlung bzw. Erwärmung des Textils erreicht werden, auch wenn die andere Seite des Peltier-Elements bzw. der andere Körper kühler bzw. wärmer ist als das Textil. Ein solcher Wärmeübertrager kann insbesondere zur Klimatisierung in einem Kraftfahrzeug eingesetzt werden, wobei das Textil bspw. im Dach des Kraftfahrzeugs vorgesehen und/oder ein Bezug eines Sitzes des Kraftfahrzeugs sein kann. Hierbei ist das Peltier-Element bevorzugt auf der vom Textil abgewandten Seite angeordnet.

Der Wärmeübertrager kann in einer beliebigen Anwendung zum Einsatz kommen. Zu denken ist insbesondere an den Einsatz des Wärmeübertragers in einem Kraftfahrzeug.

Der Wärmeübertrager kann selbstverständlich auch zwei oder mehrere solche Peltier-Elemente aufweisen. Dies erlaubt insbesondere die Ausgestaltung des Wärmeübertragers in einer erhöhten Vielfalt, insbesondere hinsichtlich der Größe und/oder Form bzw. Geometrie. Hierdurch ist es möglich, den Wärmeübertrager auch in schwierigen räumlichen Gegebenheiten und/oder bei komplizierten Verläufen des zu temperierenden Körpers einzusetzen. Bevorzugt ist es, wenn zumindest zwei der Peltier-Elemente elektrisch in Reihe geschaltet sind.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: einen Schnitt durch einen thermoelektrischen Wärmeübertrager mit einem Peltier-Element,
- Fig. 2: das Peltier-Element aus Fig. 1,
- Fig. 3: das Peltier-Element bei einem anderen Ausführungsbeispiel,
- Fig. 4: den Wärmeübertrager bei einem anderen Ausführungsbeispiel,
- Fig. 5: einen anderen Schnitt durch den Wärmeübertrager bei einem weiteren Ausführungsbeispiel,
- Fig. 6: die Ansicht des Wärmeübertragers auf Fig. 1 bei einem anderen Ausführungsbeispiel,
- Fig. 7 bis 9: unterschiedliche Verfahrensschritte zum Herstellen des Peltier-Elements anderen Ausführungsbeispiels,
- Fig. 10 bis 17: einen Ausschnitt des Peltier-Elements bei jeweils unterschiedlichem Ausführungsbeispiel.

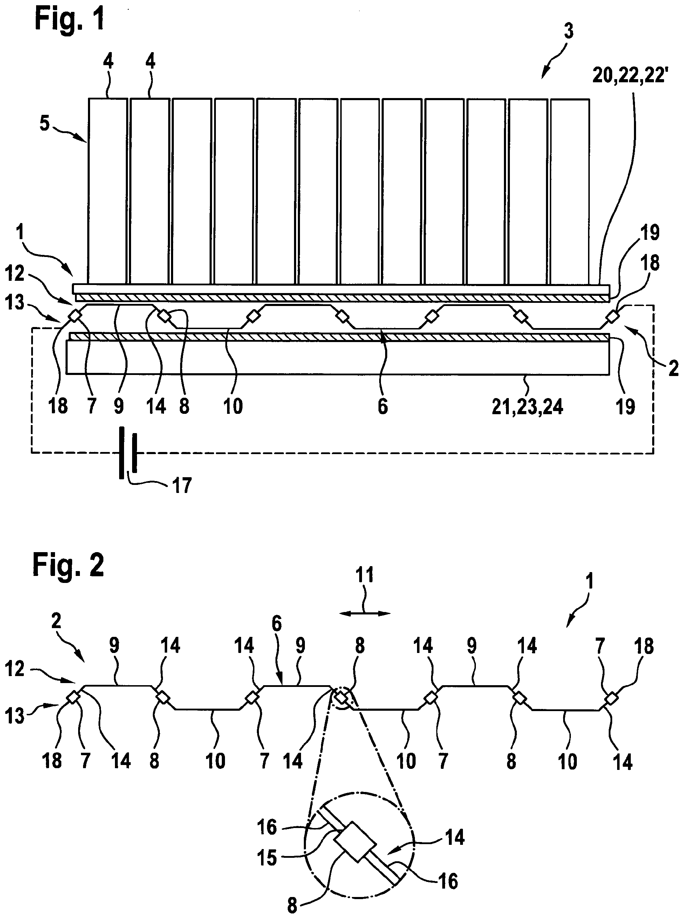

In Fig. 1 ist ein thermoelektrischer Wärmeübertrager 1 mit einem Peltier-Element 2 gezeigt, das in Fig. 2 gesondert dargestellt ist. Der Wärmeübertrager 1 kommt in einem Kraftfahrzeug 3 zum Einsatz und dient im gezeigten Beispiel der Temperierung eines mehrere Zellen 4 aufweisenden Akkumulators 5. Das Peltier-Element 2 weist eine Blech-Struktur 6 sowie eine Vielzahl von n-dotierten N-Halbleitern 7 und p-dotierten P-Halbleitern 8 auf. Die Blechstruktur 6 dient der elektrischen Kontaktierung und/oder mechanischen Verbindung der Halbleitern 7, 8 und weist erste Blechabschnitte 9 sowie zweite Blechabschnitte 10 auf, die entlang einer Erstreckung 11 des Peltier-Elements 2 abwechselnd angeordnet sind, wobei die ersten Blechabschnitte 9 sowie die zweiten Blechabschnitte 10 im gezeigten Beispiel parallel angeordnet sind. Hierbei bilden die ersten Blechabschnitte 9 eine erste Seite 12 und die zweiten Blechabschnitte 10 eine von der ersten Seite 12 beabstandete und der ersten Seite 12 gegenüberliegende zweite Seite 13 des Peltier-Elements 2. Die Blechstruktur 6 weist ferner Schenkel 14 auf, wobei jeweils ein solcher Schenkel 14 die entlang des Peltier-Elements 2 bzw. entlang der Erstreckung 11 benachbarten Blechabschnitte 9, 10 miteinander verbindet. Das heißt, dass der jeweilige Schenkel 14 einen solchen ersten Blechabschnitt 9 mit einem solchen zweiten Blechabschnitt 10 verbindet. Die Halbleiter 7, 8 sind entlang der Blechstruktur 6 abwechselnd in den Schenkeln 14 integriert. Das heißt, dass entlang der Blechstruktur 6 abwechselnd ein solcher N-Halbleiter 7 und ein solcher P-Halbleiter 8 in den Schenkeln 14 integriert sind. Die Einheit aus Blechstruktur 6 und Halbleiter 7, 8 ist also zusammenhängend. Die Integration der Halbleiter 7, 8 erfolgt, wie in der vergrößerten Darstellung der Fig. 2 gezeigt, durch eine Unterbrechung oder Aussparung 15 des jeweiligen Schenkels 14 in der der Halbleiter 7, 8 angeordnet ist, derart, dass ein elektrischer Stromfluss in der Aussparung 15 ausschließlich über den Halbleiter 7, 8 erfolgt. Im gezeigten Ausführungsbeispiel wird die Aussparung dabei von beabstandeten Schenkelabschnitten 16 begrenzt, die mit dem zugehörigen Halbleiter 7, 8 in elektrischem Kontakt stehen. Dabei ist zu erkennen, dass der jeweilige Schenkel 14 geneigt zu den zugehörigen Blechabschnitten 9, 10 verläuft. Somit sind die Seiten 12, 13 des Peltier-Elements 2 voneinander beabstandet.

Im gezeigten Ausführungsbeispiel ist im jeweiligen Schenkel 14 ein einziger solcher Halbleiter 7, 8 integriert. Hierdurch sind in entlang des Peltier-Elements 2 bzw. der Erstreckungsrichtung 11 benachbarten Schenkeln 14 abwechselnd ein solcher N-Halbleiter 7 und ein solcher P-Halbleiter 8 integriert. Dabei sind die Schenkel 14, in denen die N-Halbleiter 7 angeordnet sind und die Schenkel 14, in denen die P-Halbleiter 8 angeordnet sind, jeweils parallel angeordnet.

Die Blechstruktur 6 wird also einerseits zur elektrischen Kontaktierung der Halbleiterelemente 7, 8 eingesetzt und dient darüber hinaus als wärmeübertragende Struktur, wobei die Wärmeübertragung im gezeigten Beispiel insbesondere über die Blechabschnitte 9, 10 erfolgt. Liegt, wie in Fig. 1 gezeigt, über eine Spannungsquelle 17 eine Spannung an der Blechstruktur 6 an, die hierfür an gegenüberliegenden Enden mit elektrischen Anschlüssen 18 versehen ist, erfolgt, je nach Polung der Spannungsquelle 17 und somit der Bestromung des Peltier-Elements 2 ein Wärmefluss von der ersten Seite 12 zur zweiten Seite 13 oder umgekehrt.

Das Peltier-Element 2 ist aufgrund der flexiblen Eigenschaft der Blechstruktur 6 ebenfalls flexibel. Hierdurch können insbesondere im Betrieb des Peltier-Elements 2 bzw. des Wärmeübertragers 1 auftretende thermische Spannungen abgebaut werden. Darüber hinaus ist das Peltier-Element 2 leicht verformbar und lässt sich dementsprechend an unterschiedliche Geometrien anpassen.

Die Anordnung der Blechabschnitte 9, 10 und der Schenkel 14 führt hierbei dazu, dass das Peltier-Element 2 in mehreren Richtungen flexibel ist, insbesondere thermische Spannungen in mehreren Richtungen abbauen kann.

Beim Einsatz des Peltier-Elements 2 im in Fig. 1 gezeigten Wärmeübertrager 1 sind die erste Seite 12 bzw. die ersten Blechabschnitte 9 über eine elektrisch isolierende, insbesondere dielektrische, Schicht 19 gegenüber einem ersten Körper 20 des Wärmeübertragers 1 elektrisch isoliert, wobei die dielektrische Schicht 19 zwischen der gesamten ersten Seite 12 des Peltier-Elements 2 und dem ersten Körper 20 vorgesehen ist. Zudem ist die zweite Seite 13 des Peltier-Elements 2 bzw. die zweiten Blechabschnitte 10 mittels einer solchen Schicht 19 elektrisch gegenüber einen zweiten Körper 21 isoliert, wobei die Schicht 19 zwischen der gesamten zweiten Seite 13 und dem zweiten Körper 21 vorgesehen ist. Dabei steht die erste Seite 12 des Peltier-Elements 2 mit dem ersten Körper 20 und die zweite Seite 13 des Peltier-Elements 2 mit dem zweiten Körper 21 in wärmeaustauschendem Kontakt. Im Betrieb des Peltier-Elements 2 bzw. des Wärmeübertragers 1 kann somit Wärme von einem der Körper 20, 21 auf den anderen Körper 20, 21 gepumpt werden. Wird z. Bsp. Wärme vom ersten Körper 20 auf den zweiten Körper 21 gepumpt, dient der erste Körper 20 als Wärmequelle und wird gekühlt, während der zweite Körper 21 als Wärmesenke dient und erwärmt wird. Dies ist mittels des Peltier-Elements 2 auch dann möglich, wenn der erste Körper 20 eine niedrigere Temperatur aufweist als der zweite Körper 21. Durch eine Umkehrung der Bestromung des Peltier-Elements 2 kann der Wärmefluss umgekehrt werden, so dass der erste Körper 20 als Wärmesenke und der zweite Körper 21 als Wärmequelle dient. Im gezeigten Ausführungsbeispiel ist der erste Körper 20 eine Metallplatte 22 bzw. ein Heat Spreader 22', die einen über die Fläche des ersten Körpers 20 homogeneren Wärmeaustausch zwischen dem Peltier-Element 2 bzw. der ersten Seite 12 und dem Akkumulator 5 erlaubt. Das heißt, dass der erste Körper 20 im gezeigten Beispiel dazu eingesetzt wird, um einen weiteren Gegenstand, hier den Akkumulator 5, zu temperieren, beim Einsatz des ersten Körpers 20 als Wärmequelle zu kühlen. Der zweite Körper 21 ist als ein durchströmbarer Körper, insbesondere ein Rohrkörper 23 oder eine durchströmbare Platte 24 ausgestaltet, durch den ein Temperiermittel strömt. Das heißt, dass das Temperiermittel über den zweiten Körper 21 mit dem Peltier-Element 2 Wärme austauscht. Das Temperiermittel dient im gezeigten Beispiel der Kühlung des Akkumulators 5, so dass der Wärmeaustausch zwischen dem Temperiermittel und dem Akkumulator 5 mittels des Peltier-Elements 2 verstärkt und die Kühlung des Akkumulators somit verbessert wird. Analog hierzu ist es möglich, falls nötig, den Akkumulator 5 durch eine Umkehr der Bestromung des Peltier-Elements 2 zu erwärmen.

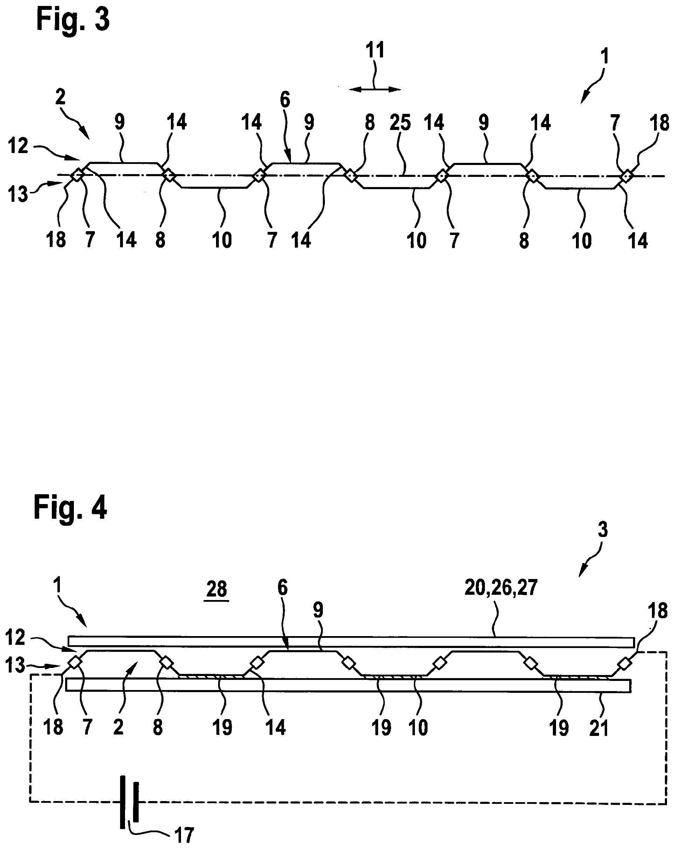

In Fig. 3 ist ein anderes Ausführungsbeispiel des Peltier-Elements 2 aus Fig. 2 gezeigt, das sich vom dem in Fig. 2 gezeigten Ausführungsbeispiel im Wesentlichen dadurch unterscheidet, dass die erste Seite 12 des Peltier-Elements 2 thermisch durch eine Trennstruktur 25 von der zweiten Seite 13 des Peltier-Elements 2 getrennt ist. Das heißt, dass die Trennstruktur 25 den Wärmefluss zwischen erster Seite 12 und zweiter Seite 13 verhindert oder zumindest reduziert. Hierdurch wird die Effizienz des Peltier-Elements 2 bzw. des Wärmeübertragers 1 verbessert, da ein unmittelbarer Austausch von Wärme zwischen erster Seite 12 und zweiter Seite 13 verhindert oder zumindest reduziert wird. Die Trennstruktur 25 kann ferner eine fluidische Trennung zwischen erster Seite 12 und zweiter Seite 13 des Peltier-Elements 2 schaffen.

In Fig. 4 ist der Wärmeübertrager 1 aus Fig. 1 bei einem anderen Ausführungsbeispiel dargestellt. Bei diesem Ausführungsbeispiel wird das Peltier-Element 2 zur unmittelbaren Temperierung der Körper 20, 21 eingesetzt. Hierbei ist der erste Körper 20 ein Textil 26, bspw. ein Bezug 27 im Dachbereich des zugehörigen Kraftfahrzeugs 3, während der zweite Körper 21 ein äußerer Bestandteil der Karosserie des Kraftfahrzeugs 3 ist. Insbesondere, wenn das Textil 26 elektrisch isolierend ist, kann die elektrische Isolierung zwischen den ersten Blechabschnitten 9 und dem Textil 26 entfallen. Die zweite Seite 13 bzw. die zweiten Blechabschnitte 10 sind elektrisch gegenüber dem zweiten Körper 21 isoliert, wobei hierzu solche Schichten 19 zum Einsatz kommen, die abschnittsweise zwischen dem jeweiligen zweiten Blechabschnitt 10 und dem zweiten Körper 21 vorgesehen sind. Mit Hilfe des Peltier-Elements 2 kann der Wärmeübertrager 1 somit zur Temperierung des Innenraums 28 des Kraftfahrzeugs 3 eingesetzt werden, indem Wärme vom ersten Körper 20 und somit vom Innenraum 28 auf den zweiten Körper 21 und somit nach außen gepumpt wird, um den Innenraum 28 zu kühlen, oder indem Wärme vom zweiten Körper 21 auf den ersten Körper 20 und in den Innenraum 28 gepumpt wird, um den Innenraum 28 zu erwärmen.

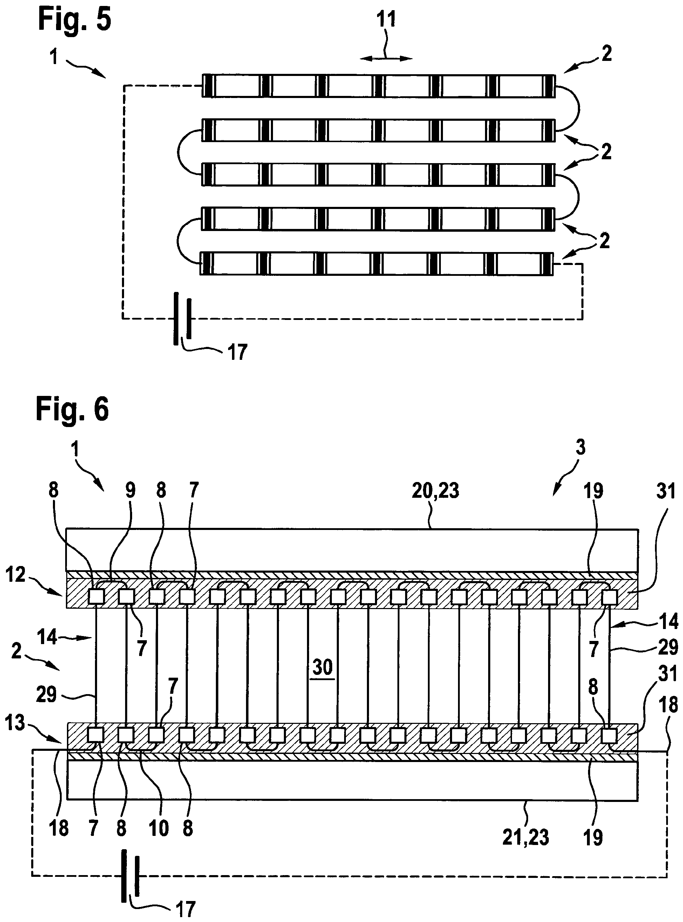

Ein anderes Ausführungsbeispiel des Wärmeübertragers 1 ist in Fig. 5 dargestellt, wobei in Fig. 5 eine Draufsicht auf mehrere solche Peltier-Elemente 2 des Wärmeübertragers 1 zu sehen ist. Es ist zu erkennen, dass die Peltier-Elemente 2 des Wärmeübertragers 1 parallel zueinander angeordnet sind, wobei die Peltier-Elemente 2 in einer Reihenschaltung miteinander verbunden und durch die gleiche Spannungsquelle 17 bestromt werden. Vorstellbar ist es dabei, die Peltier-Elemente 2 relativ zueinander beliebig anzuordnen und diese in Reihe zu schalten. Dies erlaubt die Verwendung von Körpern 20, 21 verschiedener Geometrien und/oder Größen im Wärmeübertrager 1 bzw. die Anpassung des Wärmeübertragers 1 an unterschiedliche räumliche und geometrische Gegebenheiten.

In Fig. 6 ist ein anderes Ausführungsbeispiel des Wärmeübertragers 1 mit einem anderen Ausführungsbeispiel des Peltier-Elements 2 gezeigt. Dabei ist zu erkennen, dass die Schenkel 14 des Peltier-Elements 2 alle parallel angeordnet sind und quer zu den Blechabschnitten 9, 10 verlaufen. Bei diesem Peltier-Element 2 sind im jeweiligen Schenkel 14 zwei solche Halbleiter 7, 8, nämlich ein solcher N-Halbleiter 7 und ein solcher P-Halbleiter 8, integriert, wobei die Halbleiter 7, 8 des jeweiligen Schenkels 14 beabstandet zueinander angeordnet sind. Somit entsteht im jeweiligen Schenkel 14 zwischen den Halbleitern 7, 8 ein wärmeaustauschender Abschnitt 29. In diesem Ausführungsbeispiel wird Wärme zwischen den Seiten 12, 13 und somit den Blechabschnitten 9, 10 des Peltier-Elements 2 einerseits und den Abschnitten 29 der Schenkel 14 andererseits ausgetauscht. Das heißt, dass sowohl die ersten Blechabschnitte 9 als auch die zweiten Blechabschnitte 10 und somit sowohl die erste Seite 12 als auch die zweite Seite 13 im Betrieb des Peltier-Elements 2 erwärmt werden, während die Abschnitte 29 der Schenkel 14 gekühlt werden oder, bei einer umgekehrten Bestromung des Peltier-Elements 2, die Blechabschnitte 9, 10 und somit beide Seiten 12, 13 des Peltier-Elements 2 gekühlt werden, während die Abschnitte 29 der Schenkel 14 erwärmt werden. Im gezeigten Ausführungsbeispiel sind die Abschnitte 29 der Schenkel 14 in einem Strömungsraum 30 angeordnet, der von einem zu temperierenden Fluid durchströmt wird. Die Abschnitte 29 tauschen somit im Betrieb des Peltier-Elements 2 mit dem durch den Strömungsraum 30 strömenden Fluid Wärme aus. Um diesen Wärmeaustausch zu verbessern und/oder die mit dem Fluid wärmeaustauschende Fläche zu vergrößern, sind die Halbleiter 7, 8 des jeweiligen Schenkels 14 endseitig des jeweiligen Schenkels 14 bzw. in der Nähe des jeweils benachbarten Blechabschnitts 9, 10 angeordnet. Dabei sind die Halbleiter 7, 8 außerhalb des Strömungsraums 30 angeordnet. Das heißt, dass einer der Halbleiter 7, 8 des jeweiligen Schenkels 14 auf der ersten Seite 12 außerhalb des Strömungsraum 30 und der andere Halbleiter 7, 8 außerhalb des Strömungsraums 30 auf der zweiten Seite 13 angeordnet ist. Die auf der ersten Seite 12 angeordneten Halbleiter 7, 8 und die ersten Blechabschnitte 9 sind in einem thermisch isolierenden Block 31 angeordnet, insbesondere eingebettet, um eine entsprechende thermische Trennung zwischen dem Strömungsraum 30 und der ersten Seite 12 bzw. den auf der ersten Seite 12 angeordneten Halbleitern 7, 8 zu erzielen. Analog hierzu sind die zweiten Blechabschnitte 10 sowie die auf der zweiten Seite 13 angeordneten Halbleiter 7, 8 in einem thermisch isolierenden Block 31 angeordnet, insbesondere eingebettet, um eine thermische Trennung zwischen der zweiten Seite 13 bzw. den zweiten Blechabschnitten 10 sowie den auf der zweiten Seite 13 angeordneten Halbleitern 7, 8 und dem Strömungsraum 30 zu erzielen. Die Blechabschnitte 9, 10 ragen dabei auf der vom Strömungsraum 30 abgewandten Seite aus dem Block 31 heraus. Im Wärmeübertrager 1 stehen die Blechabschnitte 9 und somit die erste Seite 12 über eine elektrisch isolierende Schicht 19 mit dem ersten Körper 20 in wärmetauschendem Kontakt. Die zweiten Blechabschnitte 10 und somit die zweite Seite 13 stehen über eine entsprechende, elektrisch isolierende Schicht 19 mit dem zweiten Körper 21 in wärmeaustauschendem Kontakt. Somit kann das Peltier-Element 2 Wärme von dem durch den Strömungsraum 30 strömenden Fluid zu den Körpern 20, 21 pumpen, um das Fluid zu kühlen. Alternativ kann durch eine umgekehrte Bestromung des Peltier-Elements Wärme von den Körpern 20, 21 auf das Fluid gepumpt werden, um das Fluid zu erwärmen.

Im gezeigten Beispiel sind die Körper 20, 21 jeweils als Rohrkörper 23 ausgebildet, durch die ein Temperiermittel strömt. Im Wärmeübertrager 1 erfolgt also ein Wärmeaustausch zwischen dem Fluid und dem Temperiermittel, wobei das Fluid und das Temperiermittel bevorzugt fluidisch voneinander getrennt sind. Im gezeigten Ausführungsbeispiel wird also eine (nicht gezeigte) üblicherweise zwischen den Temperiermittel führenden Rohrkörpern 23 vorgesehene Rippenstruktur durch das Peltier-Element 2 ersetzt.

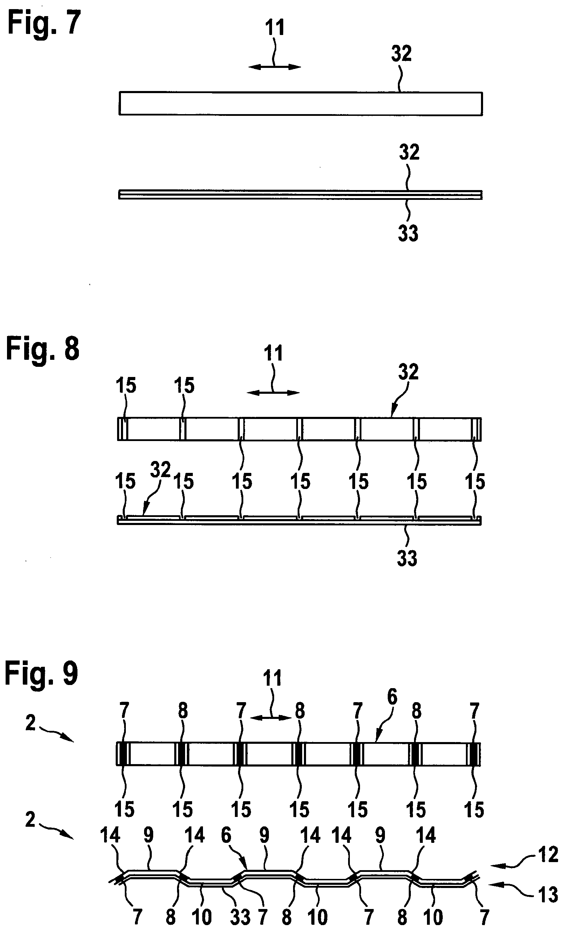

In den Fig. 7 bis 9 sind verschiedene Verfahrensschritte zum Herstellen des in Fig. 2 gezeigten Peltier-Elements 2 dargestellt, wobei die jeweilige Figur in einer oberen Ansicht eine Draufsicht und in einer unteren Ansicht eine Seitenansicht zeigt.

Entsprechend Fig. 7 wird zunächst ein Blech 32 zur Verfügung gestellt, das bandförmig ausgebildet ist. Wie aus der unteren Ansicht der Fig. 7 hervorgeht, ist das Blech 32 auf einer Unterseite mit einer Trägerplatte 33 versehen, die der Stabilisierung des Blechs 32, insbesondere in den nachfolgenden Verfahrensschritten, dient. Die Trägerplatte 33 ist bevorzugt elektrisch isolierend ausgebildet.

Entsprechend Fig. 8 wird das Blech 32 mit Aussparungen 15 versehen, die in Erstreckungsrichtung 11 des Blechs 32 parallel und äquidistant angeordnet sind. Aus Fig. 8 geht dabei hervor, dass die Aussparungen 15 im gezeigten Beispiel in den beiden quer zur Erstreckungsrichtung 11 verlaufenden Richtungen gänzlich durch das Blech 32 verlaufen und somit eine Unterbrechung des Blechs 32 bewirken. Diese Aussparungen 15 erstrecken sich dabei nicht in die Trägerplatte 33 hinein, so dass die voneinander getrennten Bereiche des Blechs 32 zueinander fixiert bleiben.

Anschließend werden in Erstreckungsrichtung 11 abwechselnd N-Halbleiter 7 und P-Halbleiter 8 in die Aussparungen 15 integriert. Anschließend erfolgt, wie insbesondere in der Seitenansicht der Fig. 9 zu erkennen ist, ein Umformen des mit den Halbleitern 7, 8 versehenen Blechs 32 zum Herstellen des gezeigten Peltier-Elements 2.

Anschließend kann die Trägerplatte 33 entfernt werden. Dieses Ausführungsbeispiel unterscheidet sich von dem in Fig. 2 gezeigten Ausführungsbeispiel insbesondere dadurch, dass die Halbleiter 7, 8 die Blechstruktur 7 bzw. die zugehörigen Schenkel 14 nicht überragen. Das heißt, dass die Halbleiter 7, 8 nicht aus den zugehörigen Aussparungen 15 überstehen, sondern bündig mit dem zugehörigen Schenkel 14 abschließen.

Alternativ kann die Trägerplatte 10 am Peltier-Element 2 zum Ausbilden eines anderen Ausführungsbeispiels des Peltier-Elements 2 verbleiben. Die Trägerplatte 10 dient in diesem Fall einerseits der mechanischen Stabilisierung des Peltier-Elements 2 und andererseits der elektrischen Isolierung der zweiten Blechteile 10 bzw. der zweiten Seite 13, so dass entsprechende, in den vorstehenden Figuren gezeigte elektrisch isolierende Schichten 19 entfallen können.

Analog zur vorstehend in den Fig. 7 bis 9 gezeigten Vorgehensweise kann auch das in Fig. 6 gezeigte Peltier-Element 2 hergestellt werden, wobei hierzu insbesondere eine andere Beabstandung der Aussparungen 15 sowie ein anderes Umformen erfolgen.

Das Einbringen bzw. Integrieren der Halbleiter 7, 8 in die Aussparungen 15 kann auf beliebige Weise erfolgen. Vorstellbar ist insbesondere eine Beschichtung des Blechs 32 bzw. in den Aussparungen 15 des Blechs 32, bspw. durch sputtern. Vorstellbar ist es auch, bereits vorgefertigte Halbleiter 7, 8 in die Aussparungen 15 einzusetzen.

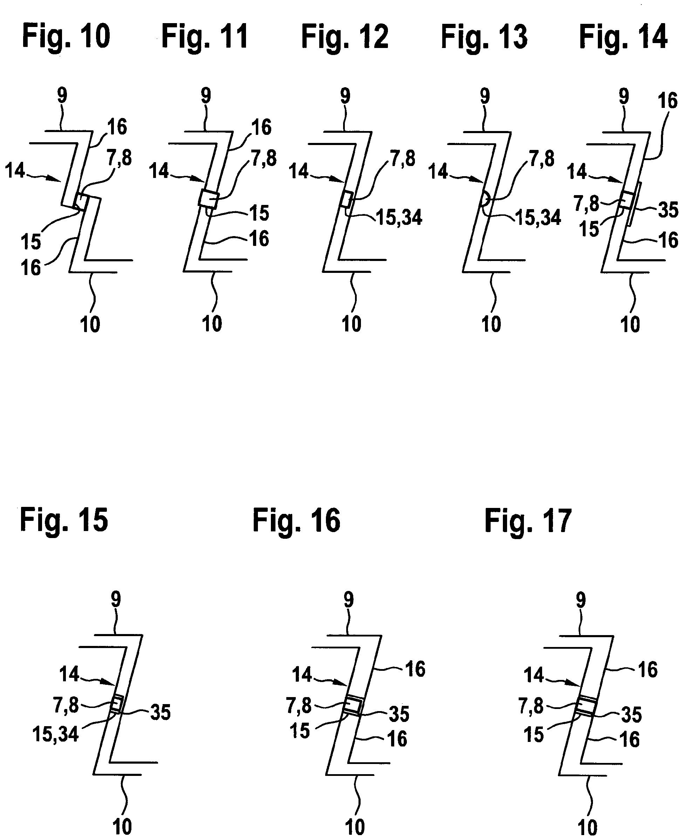

In Fig. 10 ist ein Ausführungsbeispiel gezeigt, bei dem das Blech zunächst umgeformt, anschließend eine solche Aussparung 15 vorgesehen und dann mit dem Halbleiter 7, 8 zur Integration des Halbleiters 7, 8 in den zugehörigen Schenkel 14 versehen wird. Bei diesem Ausführungsbeispiel weist der Schenkel 14 zwei zueinander versetzte, parallel verlaufende Schenkelabschnitte 16 auf.

In Fig. 11 ist ein Ausführungsbeispiel gezeigt, bei dem die Schenkelabschnitte 16 fluchtend zueinander angeordnet sind, wobei der Halbleiter 7, 8 die Aussparung 15 beidseitig überragt.

In Fig. 12 ist ein anderes Ausführungsbeispiel gezeigt, bei dem das Blech 32 nicht mit einer durchgehenden Aussparung 15 sondern mit einer Aussparung 15 in Form einer Nut 34 versehen ist, die gänzlich mit dem Halbleiter 7, 8 gefüllt ist. Hierdurch entsteht im Schenkel 14 keine Unterbrechung, so dass der Schenkel 14 und somit das Peltier Element 2 mechanisch stabiler ist.

Fig. 13 zeigt ein Ausführungsbeispiel, das sich von dem in Fig. 12 gezeigten Ausführungsbeispiel insbesondere durch die Form der Nut 34 und somit des Halbleiters 7, 8 unterscheidet. Während in den zuvor gezeigten Figuren eckige Halbleiter 7, 8 zu sehen sind, sind der Halbleiter 7, 8 sowie die zugehörige Nut 34 in Fig. 13 abgerundet ausgebildet.

In Fig. 14 ist ein Ausführungsbeispiel dargestellt, bei dem eine solche, durchgehende Aussparung 15 vorgesehen ist, die den Schenkel 14 in den Schenkelabschnitten 16 unterteilt. Zudem ist eine elektrisch und/oder thermisch isolierende Verstärkungsplatte 35 vorgesehen, welche die Schenkelabschnitte 16 einseitig miteinander verbindet und den Schenkel 14 somit mechanisch stabilisiert. Alternativ kann die Trägerplatte 35 aus einem Metall hergestellt und/oder elektrisch leitend sein. Vorstellbar ist es hierbei insbesondere, den Halbleiter 7, 8 zunächst auf die Trägerplatte 35 aufzubringen und die Trägerplatte 35 mit dem Halbleiter 7, 8 anschließend zusammen am Schenkel 14 anzubringen.

Die Fig. 15 bis 17 zeigen Ausführungsformen, bei denen jeweils ebenfalls eine solche Trägerplatte 35 zum Einsatz kommt, wobei in Fig. 15 eine solche, als Nut 34 ausgestaltete Aussparung 15 zu sehen ist, während in den Fig. 16 und 17 jeweils eine solche, den Schenkel 14 in zwei Schenkelabschnitte 16 unterteilende Aussparung 15 vorgesehen ist. Bei diesen Ausführungsbeispielen ist die Trägerplatte 35 im Querschnitt größer als der zugehörige Halbleiter 7, 8.

## Patentansprüche

1. Peltier-Element (2) für einen thermoelektrischen Wärmeübertrager (1), mit n-dotierten N-Halbleitern (7) sowie p-dotierten P-Halbleitern (8) und mit einer Blechstruktur (6) zur elektrischen Kontaktierung der Halbleiter (7, 8),
- wobei die Blechstruktur (6) erste Blechabschnitte (9) und zweite Blechabschnitte (10) aufweist, die entlang einer Erstreckung (11) des Peltier-Elements (2) abwechselnd angeordnet sind,
- wobei die ersten Blechabschnitte (9) eine erste Seite (12) des Peltier-Elements (2) und die zweiten Blechabschnitte (10) eine von der ersten Seite (12) beabstandete zweite Seite (13) des Peltier-Elements (2) bilden,
- wobei die Blechstruktur (6) Schenkel (14) aufweist,
- wobei jeweils ein solcher Schenkel (14) die entlang des Peltier-Elements (2) benachbarten Blechabschnitte (9, 10) miteinander verbindet und geneigt zu den zugehörigen Blechabschnitten (9, 10) verläuft,
**dadurch gekennzeichnet,**
**dass** entlang der Blechstruktur (6) abwechselnd ein solcher N-Halbleiter (7) und ein solcher P-Halbleiter (8) in den Schenkeln (14) integriert sind.

2. Peltier-Element nach Anspruch 1,
**dadurch gekennzeichnet,**
**dass** die erste Seite (12) und die zweite Seite (13) gegenüberliegend angeordnet sind.

3. Peltier-Element nach Anspruch 1 oder 2,
**dadurch gekennzeichnet,**
**dass** an gegenüberliegen Enden der Blechstruktur (6) jeweils ein elektrischer Anschluss (18) zur Bestromung des Peltier-Elements (2) vorgesehen ist.

4. Peltier-Element nach einem der Ansprüche 1 bis 3,
**dadurch gekennzeichnet,**
**dass** die erste Seite (12) thermisch und/oder fluidisch von der zweiten Seite (13) isoliert ist.

5. Peltier-Element nach einem der Ansprüche 1 bis 4,
**dadurch gekennzeichnet,**
**dass** im jeweiligen Schenkel (14) ein einziger solcher Halbleiter (7, 8) integriert ist.

6. Peltier-Element nach einem der Ansprüche 1 bis 4,
**dadurch gekennzeichnet,**
- **dass** das Peltier-Element (2) einen zwischen den ersten Blechabschnitten (9) und den zweiten Blechabschnitten (10) angeordneten Strömungsraum (30) aufweist, der von einem zu temperierenden Fluid durchströmbar ist,
- **dass** im jeweiligen Schenkel (14) ein solcher N-Halbleiter (7) und ein solcher P-Halbleiter (8) integriert sind, wobei einer der Halbleiter (7, 8) auf der ersten Seite (12) außerhalb des Strömungsraums (30) und der andere Halbleiter (7, 8) auf der zweiten Seite (13) außerhalb des Strömungsraums (30) angeordnet ist.

7. Peltier-Element nach Anspruch 6,
**dadurch gekennzeichnet,**
- **dass** die auf der ersten Seite (12) angeordneten Halbleiter (7, 8) und die ersten Blechabschnitte (9) gegenüber dem Strömungsraum (30) thermisch isoliert sind, und/oder
- **dass** die auf der zweiten Seite (13) angeordneten Halbleiter (7, 8) und die zweiten Blechabschnitte (10) gegenüber dem Strömungsraum (3) thermisch isoliert sind.

8. Verfahren zum Herstellen eines Peltier-Elements (2) nach einem der vorhergehenden Ansprüche, mit den Verfahrensschritten:
- Bereitstellen eines Blechs (32),
- Einbringen von entlang des Blechs (32) beanstandeten Aussparungen (15) in das Blech (32),
- Abwechselndes Integrieren von n-dotierten N-Halbleiten (7) und p-dotierten P-Halbleiten (8) in die Aussparungen (15) des Blechs (32),
- Umformen des mit den Halbleitern (7, 8) versehenen Blechs (32) zum Peltier-Element (2), derart, dass
i) erste Blechabschnitte (9) und zweite Blechabschnitte (10) entlang der Erstreckung (11) des Peltier-Elements (2) abwechselnd angeordnet sind, wobei die ersten Blechabschnitte (9) eine erste Seite (12) und die zweiten Blechabschnitte (10) eine von der ersten Seite (12) beabstandete zweite Seite (13) des Peltier-Elements (2) bilden,
ii) jeweils ein Schenkel (14) die entlang des Peltier-Elements (2) benachbarten Blechabschnitte (9, 10) miteinander verbindet und geneigt zu den zugehörigen Blechabschnitten (9, 10) verläuft,
iii) die Halbleiter (7, 8) in den Schenkeln (14) angeordnet sind.

9. Verfahren nach Anspruch 8,
**dadurch gekennzeichnet,**
**dass** das Blech (32) mit einer mechanisch stabilisierenden Trägerplatte (33) versehen wird.

10. Verfahren nach Anspruch 9,
**dadurch gekennzeichnet,**
**dass** die Trägerplatte (33) nach dem Umformen des Blechs (32) entfernt wird.

11. Thermoelektrischer Wärmeübertrager (1), insbesondere für ein Kraftfahrzeug (3),
- mit einem Peltier-Element (2) nach einem der Ansprüche 1 bis 7,
- wobei die erste Seite (12) des Peltier-Elements (2) mit einem ersten Körper (20) wärmeübertragend verbunden ist,
- wobei die zweite Seite (13) des Peltier-Elements (2) mit einem zweiten Körper (21) wärmeübertragend verbunden ist.

12. Wärmeübertrager nach Anspruch 11,
**dadurch gekennzeichnet,**
**dass** zwischen der ersten Seite (12) und dem ersten Körper (20) und/oder zwischen der zweiten Seite (13) und dem zweiten Körper (21) eine elektrische Isolierung (19) vorgesehen ist.

13. Wärmeübertrager nach einem der Ansprüche 11 oder 12,
**dadurch gekennzeichnet,**
**dass** zumindest einer der Körper (20,21) ein von einem Temperiermittel durchströmbarer Rohrkörper (23) ist.

14. Wärmeübertrager nach Anspruch 13,
**dadurch gekennzeichnet,**
- **dass** das Peltier-Element (2) entsprechend Anspruch 6 oder 7 ausgebildet ist,
- **dass** der erste Körper (20) und der zweite Körper (21) jeweils ein solcher Rohrkörper (23) sind.

15. Wärmeübertrager nach einem der Ansprüche 11 bis 13,
**dadurch gekennzeichnet,**
**dass** zumindest einer der Körper (20, 21) ein Textil (26) ist.

## Claims

1. Peltier element (2) for a thermoelectric heat transfer device (1), having n-doped N-semiconductors (7) and p-doped P-semiconductors (8) and having a sheet-metal structure (6) for the electrical contacting of the semiconductors (7, 8),
- wherein the sheet-metal structure (6) has first sheet-metal portions (9) and second sheet-metal portions (10), which are disposed alternatingly along an extension (11) of the Peltier element (2),
- wherein the first sheet-metal portions (9) form a first side (12) of the Peltier element (2) and the second sheet-metal portions (10) form a second side (13), distanced from the first side (12), of the Peltier element (2),
- wherein the sheet-metal structure (6) has legs (14),
- wherein respectively one such leg (14) connects the sheet-metal portions (9,10) adjacent along the Peltier element (2) with one another and extends inclined towards the associated sheet-metal portions (9, 10),
**characterised in**
**that** along the sheet-metal structure (6) one such N-semiconductor (7) and one such P-semiconductor (8) are integrated alternatingly in the legs (14).

2. Peltier element according to claim 1,
**characterised in**
**that** the first side (12) and the second side (13) are arranged oppositely.

3. Peltier element according to claim 1 or 2,
**characterised in**
**that** at opposite ends of the sheet-metal structure (6) is provided respectively one electrical connection (18) for the current flow of the Peltier element (2).

4. Peltier element according to any of claims 1 to 3,
**characterised in**
**that** the first side (12) is thermally and/or fluidically insulated from the second side (13).

5. Peltier element according to any of claims 1 to 4,
**characterised in**
**that** in the respective leg (14) is integrated one single such semiconductor (7, 8).

6. Peltier element according to any of claims 1 to 4,
**characterised in**
- **that** the Peltier element (2) has a flow space (30) disposed between the first sheet-metal portions (9) and the second sheet-metal portions (10), through which a fluid to be tempered can flow,
- **that** in the respective leg (14) are integrated one such N-semiconductor (7) and one such P-semiconductor (8), wherein one of the semiconductors (7, 8) is disposed on the first side (12) externally to the flow space (30) and the other semiconductor (7, 8) is disposed on the second side (13) externally to the flow space (30).

7. Peltier element according to claim 6,
**characterised in**
- **that** the semiconductors (7, 8) disposed on the first side (12) and the first sheet-metal portions (9) are thermally insulated with respect to the flow space (30), and/or
- **that** the semiconductors (7, 8) disposed on the second side (13) and the second sheet-metal portions (10) are thermally insulated with respect to the flow space (3).

8. Method for producing a Peltier element (2) according to any of the preceding claims, having the method steps:
- provision of a metal sheet (32),
- introduction of cutouts (15) into the metal sheet (32), spaced along the metal sheet (32),
- alternating integration of n-doped N-semiconductors (7) and p-doped P-semiconductors (8) into the cutouts (15) of the metal sheet (32),
- reforming of the metal sheet (32) furnished with the semiconductors (7, 8) to form the Peltier element (2) such that
i) first sheet-metal portions (9) and second sheet-metal portions (10) are alternatingly disposed along the extension (11) of the Peltier element (2), wherein the first sheet-metal portions (9) form a first side (12), and the second sheet-metal portions (10) form a second side (13), spaced from the first side (12), of the Peltier element (2),
ii) respectively one leg (14) connects the sheet-metal portions (9, 10) adjacent along the Peltier element (2) with one another and extends inclined towards the associated sheet-metal portions (9, 10),
iii) the semiconductors (7, 8) are disposed in the legs (14).

9. Method according to claim 8,
**characterised in**
**that** the metal sheet (32) is equipped with a mechanically stabilising carrier plate (33).

10. Method according to claim 9,
**characterised in**
**that** the carrier plate (33) is removed after the reforming of the metal sheet (32).

11. Thermoelectric heat transfer device (1), in particular for a motor vehicle (3)
- having a Peltier element (2) according to any of claims 1 to 7,
- wherein the first side (12) of the Peltier element (2) is connected in a heat-transferring manner with a first body (20),
- wherein the second side (13) of the Peltier element (2) is connected in a heat-transferring manner with a second body (21).

12. Method according to claim 11,
**characterised in**
**that** between the first side (12) and the first body (20) and/or between the second side (13) and the second body (21) is provided an electrical insulation (19).

13. Method according to any of claims 11 or 12,
**characterised in**
**that** at least one of the bodies (20, 21) is a tubular body (23) through which a temperature control medium can flow.

14. Heat transfer device according to claim 13,
**characterised in**
- **that** the Peltier element (2) is designed according to claim 6 and 7,
- **that** the first body (20) and the second body (21) are respectively one such tubular body (23).

15. Method according to any of claims 11 to 13,
**characterised in**
**that** at least one of the bodies (20, 21) is a textile (26).

## Revendications

1. Élément Peltier (2) pour un échangeur de chaleur thermoélectrique (1), avec des semi-conducteurs N (7) à dopage n ainsi que des semi-conducteurs P (8) à dopage p et avec une structure en tôle (6) destinée au contact électrique des semi-conducteurs (7, 8),
- dans lequel la structure en tôle (6) comporte des premiers tronçons de tôle (9) et des deuxièmes tronçons de tôle (10) qui sont agencés en alternance le long d'une extension (11) de l'élément Peltier (2),
- dans lequel les premiers tronçons de tôle (9) forment un premier côté (12) de l'élément Peltier (2) et les deuxièmes tronçons de tôle (10) forment un deuxième côté (13), distant du premier côté (12), de l'élément Peltier (2),
- dans lequel la structure en tôle (6) comporte des branches (14),
- dans lequel une branche (14) de ce type relie à chaque fois entre eux les tronçons de tôle (9, 10) voisins le long de l'élément Peltier (2) et s'étend avec une certaine inclinaison par rapport aux tronçons de tôle (9, 10) associés,
**caractérisé en ce que**, le long de la structure en tôle (6), un semi-conducteur N (7) de ce type et un semi-conducteur P (8) de ce type sont intégrés en alternance dans les branches (14).

2. Élément Peltier selon la revendication 1, **caractérisé en ce que** le premier côté (12) et le deuxième côté (13) sont agencés en face l'un de l'autre.

3. Élément Peltier selon la revendication 1 ou 2, **caractérisé en ce qu'**il est prévu au niveau des côtés opposés de la structure en tôle (6) à chaque fois un raccordement électrique (18) pour alimenter en courant l'élément Peltier (2).

4. Élément Peltier selon l'une quelconque des revendications 1 à 3, **caractérisé en ce que** le premier côté (12) est isolé du deuxième côté (13) du point de vue thermique et/ou fluidique.

5. Élément Peltier selon l'une quelconque des revendications 1 à 4, **caractérisé en ce qu'**un seul semi-conducteur (7, 8) de ce type est intégré dans la branche (14) respective.

6. Élément Peltier selon l'une quelconque des revendications 1 à 4, **caractérisé en ce que**
- l'élément Peltier (2) comporte un espace d'écoulement (30) qui est agencé entre les premiers tronçons de tôle (9) et les deuxièmes tronçons de tôle (10) et qui peut être traversé par un fluide à thermoréguler,
- dans la branche (14) respective sont intégrés un semi-conducteur N (7) de ce type et un semi-conducteur P (8) de ce type, un des semi-conducteurs (7, 8) étant agencé sur le premier côté (12) à l'extérieur de l'espace d'écoulement (30) et l'autre semi-conducteur (7, 8) étant agencé sur le deuxième côté (13) à l'extérieur de l'espace d'écoulement (30).

7. Élément Peltier selon la revendication 6, **caractérisé en ce que**
- les semi-conducteurs (7, 8) agencés sur le premier côté (12) et les premiers tronçons de tôle (9) sont isolés du point de vue thermique par rapport à l'espace d'écoulement (30), et/ou
- les semi-conducteurs (7, 8) agencés sur le deuxième côté (13) et les deuxièmes tronçons de tôle (10) sont isolés du point de vue thermique par rapport à l'espace d'écoulement (3).

8. Procédé de fabrication d'un élément Peltier (2) selon l'une quelconque des revendications précédentes, avec les étapes de procédé :
- fourniture d'une tôle (32),
- création d'évidements (15), distants le long de la tôle (32), dans la tôle (32),
- intégration alternée de semi-conducteurs N (7) à dopage n et de semi-conducteurs P (8) à dopage p dans les évidements (15) de la tôle (32),
- mise en forme de la tôle (32), munie des semi-conducteurs (7, 8), de manière à obtenir l'élément Peltier (2), de telle sorte que
i) des premiers tronçons de tôle (9) et des deuxièmes tronçons de tôle (10) sont agencés en alternance le long de l'extension (11) de l'élément Peltier (2), les premiers tronçons de tôle (9) formant un premier côté (12) et les deuxièmes tronçons de tôle (10) formant un deuxième côté (13), distant du premier côté (12), de l'élément Peltier (2),
ii) une branche (14) relie à chaque fois entre eux les tronçons de tôle (9, 10) voisins le long de l'élément Peltier (2) et s'étend avec une certaine inclinaison par rapport aux tronçons de tôle (9, 10) associés,
iii) les semi-conducteurs (7, 8) sont agencés dans les branches (14).

9. Procédé selon la revendication 8, **caractérisé en ce que** la tôle (32) est munie d'une plaque de support (33) destinée à la stabilisation mécanique.

10. Procédé selon la revendication 9, **caractérisé en ce que** la plaque de support (33) est enlevée après la mise en forme de la tôle (32).

11. Échangeur de chaleur thermoélectrique (1), en particulier pour un véhicule automobile (3),
- avec un élément Peltier (2) selon l'une quelconque des revendications 1 à 7,
- dans lequel le premier côté (12) de l'élément Peltier (2) est relié de manière à échanger de la chaleur avec un premier corps (20),
- dans lequel le deuxième côté (13) de l'élément Peltier (2) est relié de manière à échanger de la chaleur avec un deuxième corps (21).

12. Échangeur de chaleur selon la revendication 11, **caractérisé en ce qu'**une isolation électrique (19) est prévue entre le premier côté (12) et le premier corps (20) et/ou entre le deuxième côté (13) et le deuxième corps (21).

13. Échangeur de chaleur selon l'une quelconque des revendications 11 ou 12, **caractérisé en ce qu'**au moins l'un des corps (20, 21) est un corps tubulaire (23) pouvant être traversé par un fluide de thermorégulation.

14. Échangeur de chaleur selon la revendication 13, **caractérisé en ce que**
- l'élément Peltier (2) est réalisé selon la revendication 6 ou 7,
- le premier corps (20) et le deuxième corps (21) sont chacun un corps tubulaire (23) de ce type.

15. Échangeur de chaleur selon l'une quelconque des revendications 11 à 13, **caractérisé en ce qu'**au moins l'un des corps (20, 21) est un textile (26).
